# EUROPEAN PATENT APPLICATION

(11) **EP 4 383 741 A1**
(43) Date of publication of application: **12.06.2024**
(21) Application number: 22874439.7
(22) Date of filing: 10.08.2022
(51) Int. Cl.: H04N 23/60, H04N 23/00

(54) **OPTICAL IMAGE STABILIZATION ELECTRIC MOTOR, CAMERA MODULE, AND ELECTRONIC DEVICE**

(30) Priority: 29.09.2021 CN 202111154957
(71) Applicant: Huawei Technologies Co., Ltd., Shenzhen, Guangdong 518129 (CN)
(72) Inventor: WANG, Wei, Shenzhen, Guangdong 518129 (CN); HE, Yingyong, Shenzhen, Guangdong 518129 (CN); WANG, Jianwen, Shenzhen, Guangdong 518129 (CN); LI, Dengfeng, Shenzhen, Guangdong 518129 (CN); TANG, Wei, Shenzhen, Guangdong 518129 (CN); LIN, Weichih, Shenzhen, Guangdong 518129 (CN)
(74) Representative: Körber, Martin Hans
(86) International application number: PCT/CN2022/111373
(87) International publication number: WO 2023/051043

(57) **Abstract**

Embodiments of this application provide an image stabilization motor, a camera module, and an electronic device. The image stabilization motor includes a base, a movable assembly, a suspension assembly, a driving assembly, and a flexible circuit board. The movable assembly is disposed at the bottom of the base, and includes a main circuit board and an image sensor. One end of the flexible circuit board is connected to an end surface of the main circuit board, the other end of the flexible circuit board is connected to a board-to-board connector, and at least a part of the flexible circuit board is attached to a side wall of the base in length. The suspension assembly is fixedly connected to the base, and the main circuit board is connected to the suspension assembly. The driving assembly includes a mover and a stator. The mover is fastened to the main circuit board, and the stator is mounted in the base and correspondingly disposed above the mover. The mover is configured to drive, under an action of the stator, the movable assembly to shift and/or roll on a plane on which an image sensor is located. According to the image stabilization motor, the camera module, and the electronic device provided in embodiments of this application, better image stabilization effect can be implemented by moving the image sensor.

## Description

This application claims priority to Chinese Patent Application No. 202111154957.8, filed with the China National Intellectual Property Administration on September 29, 2021 and entitled "IMAGE STABILIZATION MOTOR, CAMERA MODULE, AND ELECTRONIC DEVICE", which is incorporated herein by reference in its entirety.

### TECHNICAL FIELD

This application relates to the field of camera technologies, and in particular, to an image stabilization motor, a camera module, and an electronic device.

### BACKGROUND

With popularization of electronic devices such as a smartphone and a tablet computer, a user has an increasingly high requirement on image shooting quality of the electronic devices. When the electronic device is used to perform an image shooting operation, a jitter of the electronic device is inevitable. This severely affects the image shooting quality. Therefore, an image stabilization structure needs to be disposed in a camera module.

In the conventional technology, an image stabilization solution of the camera module is as follows: An optical image stabilization (Optical Image Stabilization, OIS) motor is disposed to move a lens or tilt a prism, to adjust a position relationship between an optical axis of the lens or the prism and an imaging plane of an image sensor, so as to correct a jitter.

However, the prism and the lens have large sizes, and space of the camera module is limited. When the prism or the lens is driven to move or roll, both a movement displacement and a roll angle are very limited. Therefore, a requirement for optical image stabilization adjustment cannot be met, and image stabilization effect is poor.

### SUMMARY

Embodiments of this application provide an image stabilization motor, a camera module, and an electronic device, so that better image stabilization effect can be implemented by moving an image sensor.

According to an aspect of embodiments of this application, an image stabilization motor is provided, including a base, a movable assembly, a suspension assembly, and a driving assembly. The movable assembly is disposed below the base. The movable assembly includes a main circuit board and an image sensor connected to the main circuit board. One end of the flexible circuit board is connected to an end surface of the main circuit board, the other end of the flexible circuit board is connected to a board-to-board connector, and at least a part of the flexible circuit board is attached to a side wall of the base in length. The suspension assembly is fixedly connected to the base, and the main circuit board is connected to the suspension assembly. The driving assembly includes a mover and a stator. The mover is fastened to the main circuit board, and the stator is mounted in the base and correspondingly disposed above the mover. After being electrified, the mover is configured to drive, under an action of the stator, the movable assembly to shift and/or roll on a plane on which an image sensor is located.

Embodiments of this application provide an image stabilization motor, and an electromagnetic driving assembly may be used to drive an image sensor, so that the image sensor implements jitter suppression in three directions: X-axis shift, Y-axis shift, and Z-axis (on an XY plane) roll, to resolve problems such as optical image instability and image rotation. In addition, the flexible circuit board attached to the side wall of the base is disposed to connect an external power supply to the main circuit board, so as to provide a reliable electrical connection and reduce occupied space.

In a possible implementation, the flexible circuit board includes a bent segment and a fixed segment. The bent segment is connected between the end surface of the main circuit board and the fixed segment. The bent segment is disposed in a bent manner and is attached to at least two side walls of the base. The fixed segment is connected to the board-to-board connector by using a connection circuit board.

The bent segment may be attached to the side walls of the base, so that the flexible circuit board may occupy less space and improve structure reliability. In addition, the flexible circuit board may provide a specific rigidity value for the image stabilization motor.

In a possible implementation, the fixed segment is attached to a top wall of the base, and the fixed segment and the connection circuit board are welded.

The fixed segment is attached to the top wall of the base. This facilitates a reliable and fixed connection between the fixed segment and the connection circuit board, and reduces overall space occupation of the flexible circuit board.

In a possible implementation, there are two flexible circuit boards, and bent segments of the two flexible circuit boards are respectively connected to two opposite end surfaces of the main circuit board.

Symmetric flexible circuit boards extending from left and right sides of the main circuit board may provide rigidity values in X and Y directions for the image stabilization motor, and work with suspension lines. This can ensure that a difference value of the entire image stabilization motor in different postures is small, and ensure stability of image stability performance of the image sensor in different postures in a moving process of the image stabilization motor.

In a possible implementation, the flexible circuit board and the main circuit board form a rigid-flexible board.

The rigid-flexible board has features of both a flexible circuit board and a printed circuit board, and has advantages such as reducing an overall assembly size, avoiding a connection error, improving reliability, and implementing three-dimensional assembling under different assembling conditions.

In a possible implementation, the suspension assembly includes a spring and a suspension line. The spring is mounted on the base, one end of the suspension line is fastened to the spring, and the other end of the suspension line is fastened to the main circuit board.

The suspension assembly has a specific rigidity in the X and Y directions. When the image sensor shifts or rolls, the suspension line may provide specific damping effect. In addition, when the image sensor is powered off, the image sensor may be ensured to return to an initial position under a specific restoring force generated when deformation of the suspension line is restored.

In a possible implementation, a mounting hole is provided on the base. The suspension line passes through the mounting hole, and the mounting hole is filled with a damping adhesive.

The mounting hole may be filled with the damping adhesive to increase the rigidity values of the suspension line in the X and Y directions, so as to ensure stability of the image stabilization performance.

In a possible implementation, a positioning boss is disposed on the base, a positioning hole is provided on the spring, and the positioning boss is clamped in the positioning hole.

The positioning hole is in clearance fit with the positioning boss, so that reliability of fastening the spring to the base can be ensured.

In a possible implementation, the mover includes a first coil and a second coil. The stator includes a first magnet and a second magnet. A length direction of the first coil extends in a first direction, a length direction of the second coil extends in a second direction, and the first direction and the second direction are two directions that are perpendicular to each other on the plane on which the image sensor is located. Both a perpendicular bisector of the length direction of the first coil and a perpendicular bisector of the length direction of the second coil pass through a center of the image sensor. The first coil and the first magnet are configured to drive the movable assembly to shift in the second direction, and the second coil and the second magnet are configured to drive the movable assembly to shift in the first direction.

After being electrified, the first coil may generate a Lorentz force in the second direction under an action of a magnetic field. After being electrified, the second coil may generate a Lorentz force in the first direction under an action of a magnetic field. Force centers of the two forces pass through the center of the image sensor. Therefore, no additional torque is generated, and only a contribution is made to shifting motion of the image sensor in the first direction and the second direction.

In a possible implementation, the mover further includes a third coil. The stator further includes a third magnet, a length direction of the third coil extends in the first direction or the second direction, and a perpendicular bisector of the length direction of the third coil does not pass through the center of the image sensor. The third coil and the third magnet are configured to drive the movable assembly to roll on the plane on which the image sensor is located.

After being electrified, the third coil may generate a Lorentz force in the first direction or the second direction under an action of a magnetic field. A driving force center of the third coil does not pass through the center of the image sensor, and there is a specific force arm. Therefore, a specific torque may be generated, to implement that the image sensor rolls along a roll center. This implements image stabilization suppression in a roll direction of the image sensor.

In a possible implementation, the movable assembly further includes an additional circuit board. The image sensor is fastened to the additional circuit board, and the additional circuit board is welded on a side that is of the main circuit board and that backs onto the base.

The image sensor is fastened to the additional circuit board, and the additional circuit board is laser-welded to the bottom of the main circuit board. This is equivalent to splitting the movable assembly into two parts: the main circuit board and the additional circuit board, thereby facilitating assembling of the image sensor.

In a possible implementation, the movable assembly further includes a light filter. The light filter is fastened to the additional circuit board, and is located on a side that is of the image sensor and that faces the base.

The light filter can filter out light of some wavelengths and allow only light of some wavelengths to pass through. This can reduce some ghost images and scattered light, and also protect the image sensor to a specific extent.

In a possible implementation, a magnetic induction device is further disposed on the main circuit board, and the magnetic induction device is disposed at a center of the mover.

The magnetic induction device is configured to sense a magnetic flux, and can monitor a relative position signal between the image sensor and an optical path center, to implement position feedback of the image sensor, and determine whether an image stabilization amplitude reaches a preset value.

In a possible implementation, a temperature sensor is further disposed on the main circuit board, and the temperature sensor is disposed in the mover.

The temperature sensor is used to sense temperature information of the main circuit board during an image stabilization process and perform closed-loop feedback, to monitor whether heat dissipation of the main circuit board is normal.

In a possible implementation, the image stabilization motor further includes a drive IC, and the drive IC is disposed on the main circuit board.

After receiving jitter data collected by a sensor like a gyroscope in the electronic device, the drive IC may calculate a required displacement compensation amount, and then control a direction and a magnitude of an electrified current of each coil, to control the driving assembly to drive the image sensor to shift or roll.

In a possible implementation, an accommodating cavity is disposed on the base. The accommodating cavity is configured to accommodate an optical part. The image sensor is located on an out-light side of the optical part. An opening is provided on the side wall or the top wall of the base. The opening is located on an in-light side of the optical part.

The optical part is disposed in the accommodating cavity, so that when the image stabilization motor drives the image sensor to move, relative motion may occur between the image sensor and the optical part, to implement image stabilization.

According to another aspect of embodiments of this application, a camera module is further provided, including a lens, a prism, and the image stabilization motor. The prism is mounted in a base, an optical axis direction of the lens is parallel to a plane on which an image sensor is located, and the prism is configured to reflect light from the lens, so that the light is perpendicular to the plane on which the image sensor is located.

An embodiment of this application provides a camera module, which may be a periscope long-focus camera module. An image stabilization motor may drive an image sensor to move, so that a relative motion occurs between the image sensor and a prism, to implement image stabilization.

According to another aspect of embodiments of this application, a camera module is further provided, including a lens and the image stabilization motor. The lens is mounted in a base, and an optical axis direction of the lens is perpendicular to a plane on which an image sensor is located.

An embodiment of this application provides a camera module, which may be a main camera module or a wide-angle camera module. An image stabilization motor may drive an image sensor to move, so that a relative motion occurs between the image sensor and a lens, to implement image stabilization.

According to another aspect of embodiments of this application, an electronic device is further provided, including the camera module.

An embodiment of this application further provides an electronic device, including the camera module provided in the foregoing embodiments of this application. The camera module has a three-axis image stabilization capability, and can implement high-quality image shooting effect, so that competitiveness of the electronic device can be improved.

Embodiments of this application provide an image stabilization motor, a camera module, and an electronic device. An electromagnetic driving assembly may be used to drive an image sensor, so that the image sensor implements jitter suppression in three directions: X-axis shift, Y-axis shift, and Z-axis (on an XY plane) roll, to resolve problems such as optical image instability, image rotation, and crosstalk and hysteresis in drive control, and has an advantage of high integration.

### BRIEF DESCRIPTION OF DRAWINGS

FIG. 1 is a schematic diagram of a jitter direction during image shooting of a mobile phone;
FIG. 2a is a schematic diagram of a structure of an image stabilization motor according to a related technology;
FIG. 2b is another schematic diagram of a structure of an image stabilization motor according to a related technology;
FIG. 3 is a schematic exploded view of a movable assembly according to an embodiment of this application;
FIG. 4 is a schematic diagram of a structure of an assembled movable assembly according to an embodiment of this application;
FIG. 5 is a schematic exploded view of a movable assembly, a base, and a suspension assembly according to an embodiment of this application;
FIG. 6 is a schematic diagram of structures of an assembled movable assembly, an assembled base, and an assembled suspension assembly according to an embodiment of this application;
FIG. 7 is a schematic diagram of a structure of a base from another perspective according to an embodiment of this application;
FIG. 8 is a schematic exploded view of a housing of an image stabilization motor and an external circuit connection structure according to an embodiment of this application;
FIG. 9 is a schematic diagram of a structure of an assembled image stabilization motor according to an embodiment of this application;
FIG. 10 is a top view of an image stabilization motor according to an embodiment of this application;
FIG. 11 is a schematic diagram of a cross section at C-C in FIG. 10;
FIG. 12 is a schematic diagram of a cross section at D-D in FIG. 10
FIG. 13 is a schematic diagram of a structure of a main circuit board according to an embodiment of this application;
FIG. 14 is a schematic diagram of a principle of an optical image stabilization driving process according to an embodiment of this application;
FIG. 15 is a schematic diagram of a driving assembly according to an embodiment of this application;
FIG. 16 is a schematic diagram of a driving assembly according to an embodiment of this application;
FIG. 17 is a schematic diagram of a driving assembly according to an embodiment of this application;
FIG. 18 is another schematic diagram of an image stabilization motor according to an embodiment of this application; and
FIG. 19 is a schematic exploded view of an image stabilization motor according to an embodiment of this application.

### Description of reference numerals:

100: base; 10: accommodating cavity; 11: mounting hole; 121 and 122: positioning bosses; 13: limiting boss; 141, 142 and 143: mounting cavities; 200: movable assembly; 21: main circuit board; 211: light-transmitting hole; 22: image sensor; 221: additional circuit board; 222: reinforcing plate; 23: light filter; 231: bearing table; 241: magnetic induction device; 242: temperature sensor; 25: anti-collision part; 26: drive IC; 300: suspension assembly; 31: spring; 311: positioning hole; 32: suspension line; 411: first coil; 412: second coil; 413: third coil; 421: first magnet; 422: second magnet; 423: third magnet; 401, 402, 403, 404, and 405: coils; 500: flexible circuit board; 51: bent segment; 52: fixed segment; 53: connection circuit board; 54: connector; 55: limiting segment; 61: upper cover; 611: opening; 62: lower cover.

### DESCRIPTION OF EMBODIMENTS

Embodiments of this application provide an electronic device, including but not limited to a device having a camera module, for example, a mobile phone, a tablet computer, a notebook computer, an ultra-mobile personal computer (ultra-mobile personal computer, UMPC), a handheld computer, a walkie-talkie, a netbook, a POS terminal, a personal digital assistant (personal digital assistant, PDA), a wearable device, a virtual reality device, a Bluetooth speaker, or a vehicle-mounted apparatus.

In embodiments of this application, a mobile phone is used as an example of the foregoing electronic device to specifically describe structures of the electronic device and the camera module.

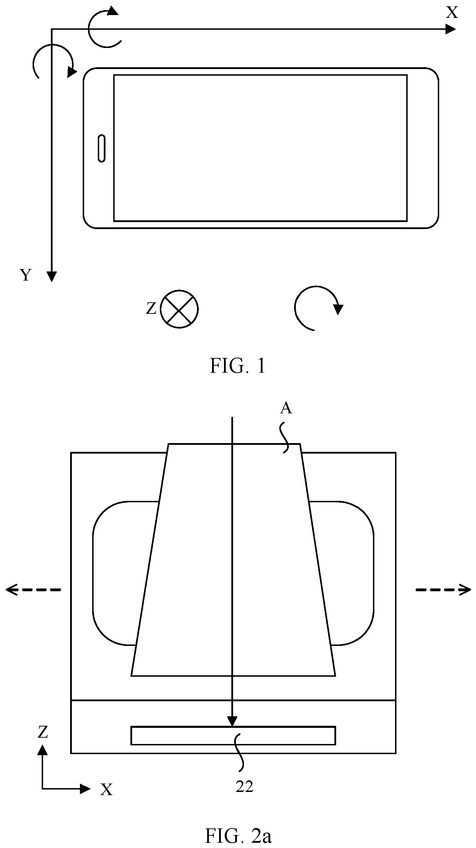

FIG. 1 is a schematic diagram of a jitter direction during image shooting of a mobile phone. Refer to FIG. 1. An X-axis may be defined as a length direction of the mobile phone, a Y-axis may be defined as a width direction of the mobile phone, and a Z-axis may be defined as a thickness direction of the mobile phone. The jitter direction of the mobile phone during image shooting includes pitch (pitch), yaw (yaw), and roll (roll), where the pitch refers to a swing on the X-axis, the yaw refers to a swing on the Y-axis, and the roll refers to a roll around the Z-axis.

It should be understood that, for a camera module inside the mobile phone, the X-axis and the Y-axis are two directions perpendicular to each other on a plane on which an image sensor is located, and the Z-axis is a direction perpendicular to the plane on which the image sensor is located, that is, a direction in which an optical axis is located.

In a related technology, an image stabilization solution of the camera module may be optical image stabilization (Optical Image Stabilization, OIS). The optical image stabilization generates displacement compensation between a moving part and a jitter direction of a body by using a physical technology, so that image blur effect caused by the jitter can be reduced.

FIG. 2a is a schematic diagram of a structure of an image stabilization motor according to a related technology. Refer to FIG. 2a. In a related technology, a lens A is mounted in the image stabilization motor, and an image sensor 22 is located on an out-light side of the lens A, as shown by a solid arrow. External light enters the lens from an in-light side of the lens A, and is imaged on the image sensor 22. The image stabilization motor may drive the lens A to shift, to perform displacement compensation and implement optical image stabilization. A shifting direction is shown by a hollow arrow in the figure.

The image stabilization motor drives the lens A to shift. The shift occurs only on an X-axis and a Y-axis. On a Z-axis, an optical axis is prone to tilt. When the optical axis tilts too much, edges and corners of a shot image are blurred. In addition, lens-shift-type optical image stabilization can only perform displacement compensation on a plane on which the image sensor 22 is located, and cannot implement correction of a roll angle in an optical axis direction. Therefore, a maximum compensation angle of the optical image stabilization is limited, and image stabilization effect is limited.

The image stabilization motor may be driven by using a plurality of methods, such as SMA (Shape Memory Alloy, shape memory alloy) wire driving and piezoelectric driving. When displacement compensation is performed by using the SMA wire driving, hysteresis effect and large crosstalk exist. This affects optical image stabilization effect. When displacement compensation is performed by using the piezoelectric driving, there are noise and life problems.

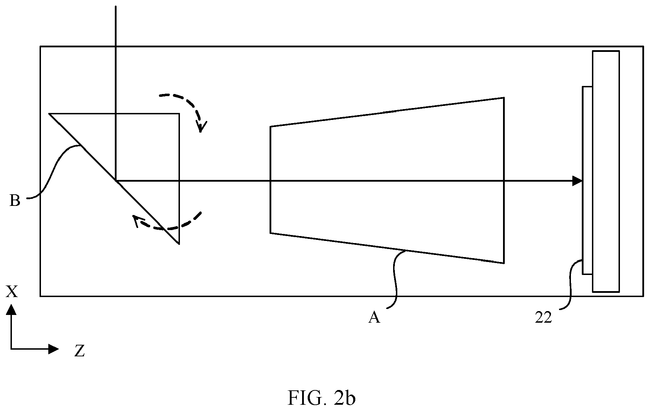

FIG. 2b is another schematic diagram of a structure of an image stabilization motor according to a related technology. Refer to FIG. 2b. In a long-focus camera module, as shown by a solid arrow in the figure, external light is reflected by a prism B, passes through a lens A, and is imaged on the image sensor 22 on an out-light side of the lens A. The image stabilization motor may drive the prism B to swing on an X-axis and a Y-axis, to perform dual-axis compensation, and implement optical image stabilization at a large angle.

However, when the image stabilization motor drives the prism B to swing, jitter suppression in a pitch direction and a yaw direction can be implemented, but jitter suppression in a roll direction cannot be implemented. In addition, when the prism B swings around two axes, an image rotation problem is inevitably introduced. Because a rotation elimination algorithm is difficult, optical image stabilization effect is affected.

In another related technology, the image stabilization motor may be combined with the foregoing two related technologies to drive the prism to roll while driving the lens to shift, to implement multi-axis displacement compensation. However, this solution has problems such as low integration, high power consumption, and a large size.

Based on the foregoing problems, embodiments of this application provide an image stabilization motor and a camera module. An electromagnetic driving assembly may be used to drive an image sensor, so that the image sensor implements jitter suppression in three directions: X-axis shift, Y-axis shift, and Z-axis (on an XY plane) roll, to resolve problems such as optical image instability, image rotation, and crosstalk and hysteresis in drive control, and has an advantage of high integration.

An embodiment of this application provides an image stabilization motor, which may be used in different types of camera modules, such as a long-focus camera module, a main camera module, and a wide-angle camera module.

The following describes in detail a structure of the image stabilization motor provided in this embodiment of this application by using an example in which the image stabilization motor is used in a periscope long-focus camera module.

The image stabilization motor provided in this embodiment of this application may include a base, a movable assembly, a suspension assembly, and a driving assembly. The movable assembly includes a main circuit board and an image sensor disposed on the main circuit board. The movable assembly may be suspended below the base by using the suspension assembly. The driving assembly is configured to drive the movable assembly to shift and/or roll on a plane on which an image sensor is located.

For ease of description, in the following accompanying drawings, a positive direction of the X-axis is the right, a positive direction of the Y-axis is the right, and a positive direction of the Z-axis is the upper.

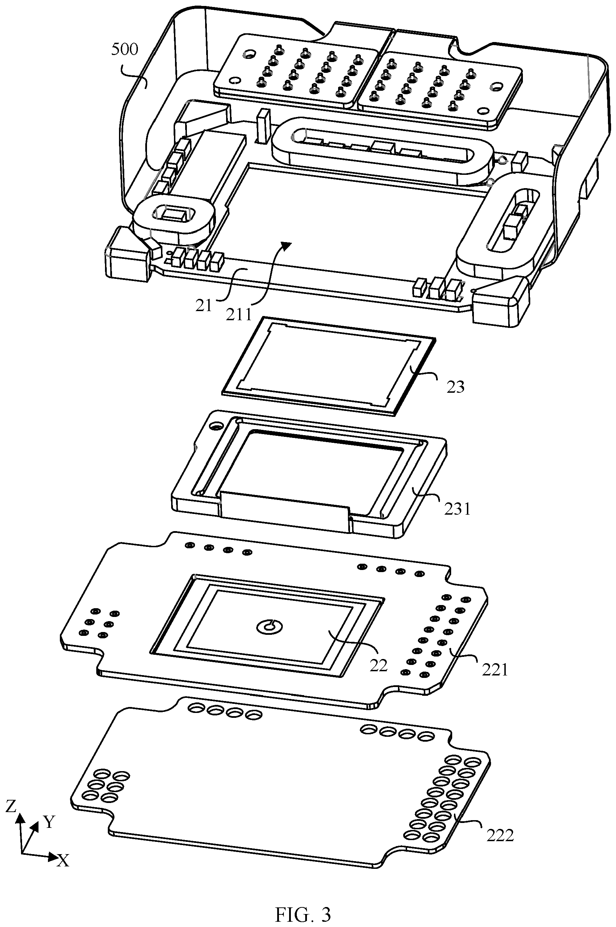

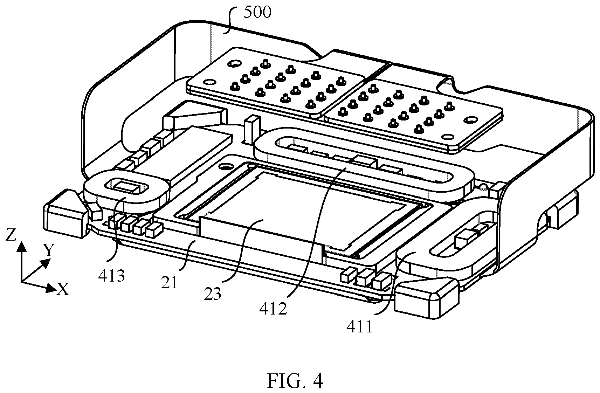

FIG. 3 is a schematic exploded view of a movable assembly according to an embodiment of this application. FIG. 4 is a schematic diagram of a structure of an assembled movable assembly according to an embodiment of this application. Refer to FIG. 3 and FIG. 4. A movable assembly 200 may include a main circuit board 21 and an image sensor 22 disposed on the main circuit board 21.

The main circuit board 21 is configured to carry the image sensor 22 and another electronic device, and the image sensor 22 is configured to perform photosensitive imaging. The main circuit board 21 may be a printed circuit board (printed circuit board, PCB), and the image sensor 22 may be a charge coupled device (charge coupled device, CCD) or a complementary metal-oxide semiconductor sensor (Complementary metal-oxide semiconductor sensor, CMOS sensor).

The image sensor 22 may be connected to an additional circuit board 221 by using a COP (Chip on board, chip onboard) process, and the additional circuit board 221 may be connected to the main circuit board 21 by using a laser welding process, so that the image sensor 22 may be electrically connected to the main circuit board 21.

The image sensor 22 and the additional circuit board 221 may be disposed at the bottom of the main circuit board 21, that is, on a side that is of the main circuit board 21 and that backs onto the base. A light-transmitting hole 211 is provided at a center of the main circuit board 21, and the image sensor 22 is opposite to the light-transmitting hole 211, so that light entering the image stabilization motor may be irradiated to the image sensor 22 through the light-transmitting hole 211.

The movable assembly 200 may further include a light filter 23. The light filter 23 may be fastened to the main circuit board 21 by using a bearing table 231. The light filter 23 and the image sensor 22 are disposed opposite to each other, and the light filter 23 is located above the image sensor 22, that is, the light filter 23 is located on a side that is of the image sensor 22 and that faces the substrate. The light filter 23 may be bonded to the bearing table 231. The bearing table 231 may be of a framework structure, and is disposed around the light filter 23 without blocking the image sensor 22. The bearing table 231 may be bonded to the additional circuit board 221.

After light outside the camera module enters an optical part in the image stabilization motor, the light may sequentially pass through the light filter 23 and the image sensor 22, and finally an optical signal is converted into a target image signal under an action of the image sensor 22. The light filter 23 can filter out light of some wavelengths and allow only light of some wavelengths to pass through. This can reduce some ghost images and scattered light, and also protect the image sensor 22 to a specific extent. For example, the light filter 23 may be an infrared light filter, which can filter out light of an infrared band and allow light of another band to pass through.

The movable assembly 200 may further include a reinforcing plate 222. The reinforcing plate 222 may be bonded to the bottom of the additional circuit board 221, that is, bonded to a side that is of the additional circuit board 221 and that backs onto the main circuit board 21. The reinforcing plate 222 may be a metal plate like a stainless steel plate. The reinforcing plate 222 may assist in laser welding, increase overall structural strength of the movable assembly 200, and protect the main circuit board 21 and the image sensor 22. In addition, the reinforcing plate 222 has good thermal conductivity, and a copper foil or graphene may be attached to the reinforcing plate 222, to implement good heat dissipation.

The main circuit board 21, the additional circuit board 221, the image sensor 22, the light filter 23, the bearing table 231, and the reinforcing plate 222 jointly form the movable assembly 200, so that when an electromagnetic driving assembly drives the movable assembly 200 to shift or roll, a relative motion occurs between the image sensor 22 and an optical part in the camera module, to implement image stabilization.

It is not difficult to understand that, the light filter 23 and the image sensor 22 are fastened to the additional circuit board 221, and the additional circuit board 221 is disposed at the bottom of the main circuit board 21 through laser welding. This is equivalent to splitting the movable assembly 200 into two parts: the main circuit board 21 and the additional circuit board 221, thereby facilitating assembling of the image sensor 22.

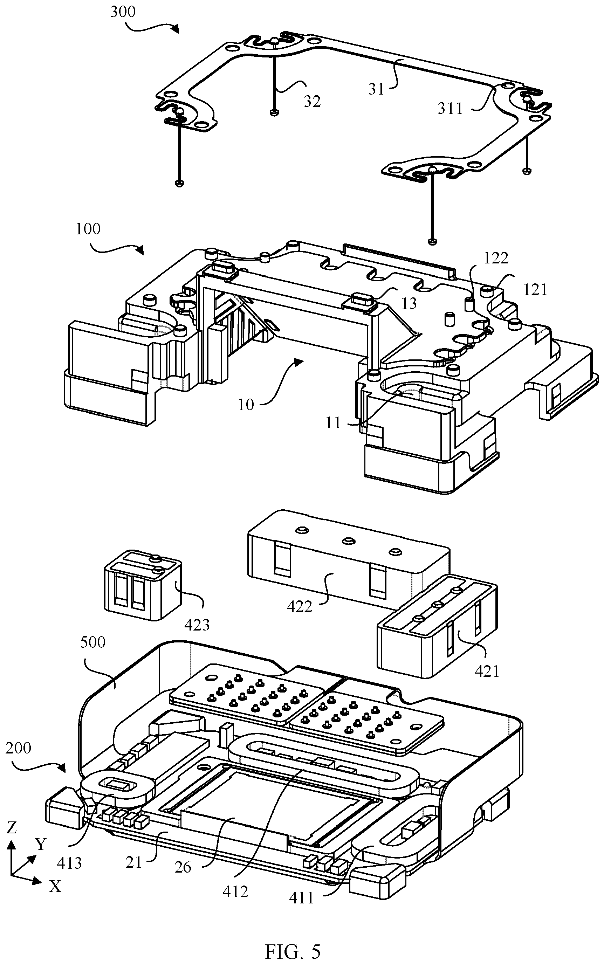

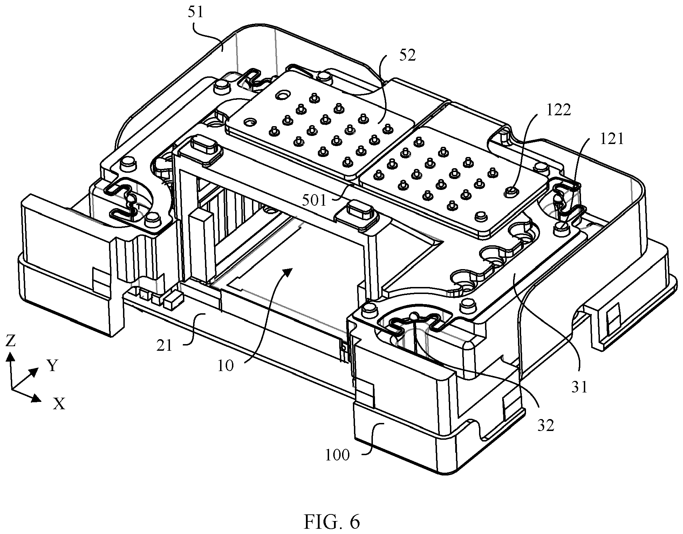

FIG. 5 is a schematic exploded view of a movable assembly, a base, and a suspension assembly according to an embodiment of this application. FIG. 6 is a schematic diagram of structures of an assembled movable assembly, an assembled base, and an assembled suspension assembly according to an embodiment of this application. Refer to FIG. 5 and FIG. 6. The image stabilization motor may further include a base 100 and a suspension assembly 300. The movable assembly 200 may be suspended at the bottom of the base 100 by using the suspension assembly 300.

The suspension assembly 300 may include a spring 31 and a suspension line 32. The spring 31 may be fastened to the base 100, and the suspension line 32 may be connected between the spring 31 and the main circuit board 21, so that the main circuit board 21 is suspended below the base 100. A through hole may be provided on the main circuit board 21, one end of the suspension line 32 is welded in the through hole, and the other end of the suspension line 32 is welded on the spring 31. A plurality of positioning holes 311 may be provided on the spring 31, and a plurality of positioning bosses 121 may be disposed on the base 100. The positioning holes 311 are in clearance fit with the positioning bosses 121, so that the spring 31 is fastened to the base 100.

There may be four suspension lines 32 that are respectively connected to four corners of the main circuit board 21. The four suspension lines may be disposed to make suspension effect even. The suspension line 32 has a specific rigidity in X and Y directions. When the image sensor 22 shifts or rolls, the suspension line 32 may provide specific damping effect. In addition, when the image sensor 22 is powered off, the image sensor 22 may be ensured to return to an initial position under a specific restoring force generated when deformation of the suspension line 32 is restored.

In addition, a rigidity value of the suspension line 32 in a Z direction, that is, a direction parallel to an optical path, is large, so that it may be ensured that in a moving process of the movable assembly 200, a plane on which the image sensor 22 is located keeps perpendicular to a receiving optical path, that is, it is ensured that the image sensor 22 is always located on an XY plane, and no tilt outside the plane is generated. This ensures final overall imaging effect of the entire camera module.

A mounting hole 11 is provided on the base 100, the mounting hole 11 may extend along a Z-axis, the spring 31 is fastened to a top of the base 100, the main circuit board 21 is located at the bottom of the base 100, and the suspension line 32 passes through the mounting hole 11 to connect the spring 31 to the main circuit board 21. The mounting hole 11 may be filled with a damping adhesive to increase rigidity values of the suspension line 32 in the X and Y directions, to ensure stability of image stabilization performance.

An accommodating cavity 10 is disposed on the base 100. The accommodating cavity 10 is configured to accommodate an optical part, for example, a prism or a periscope reflector. The accommodating cavity 10 is disposed above the main circuit board 21, and an opening is provided on a side wall of the base 100. The opening may be located on the XZ plane in the figure. The opening is a light inlet of the accommodating cavity 10. Light enters the optical part from the light inlet, and then is reflected to the image sensor 22.

It should be understood that, the mounting hole 11 is provided around the accommodating cavity 10, and does not interfere with the light inlet of the accommodating cavity 10. An edge that is of the spring 31 and that corresponds to the light inlet of the accommodating cavity 10 is disposed as a notched edge, to prevent the spring 31 from blocking light.

Still refer to FIG. 3 to FIG. 6. In embodiments of this application, the image stabilization motor may further include a flexible circuit board 500. The main circuit board 21 may be connected to the flexible circuit board 500. The flexible circuit board 500 is configured to connect the main circuit board 21 to an external power supply, to supply power to the main circuit board 21, the image sensor 22, and the like.

The flexible circuit board 500 is a circuit board made of polyimide or a polyimide film as a base material, and has an excellent feature of free bending and folding. In this embodiment of this application, the flexible circuit board 500 and the main circuit board 21 may form a rigid-flexible board. The rigid-flexible board refers to a circuit board that is formed by combining a flexible circuit board and a printed circuit board through a process like press-fitting, and has features of the flexible circuit board and the printed circuit board. The rigid-flexible board has advantages such as reducing an overall assembly size, avoiding a connection error, improving reliability, and implementing three-dimensional assembling under different assembling conditions.

The flexible circuit board 500 may include a bent segment 51 and a fixed segment 52. The bent segment 51 is connected between the main circuit board 21 and the fixed segment 52. The fixed segment 52 may be configured to connect to an external power supply. The bent segment 51 may be attached to a side wall of the base 100, and the fixed segment 52 may be attached to a top wall of the base 100, so that the flexible circuit board 500 can reduce occupied space and improve structural reliability.

A positioning boss 122 may be further disposed on the top wall of the base 100, and a positioning hole may be provided on the fixed segment 52. When the fixed segment 52 is attached to the top wall of the base 100, the positioning hole may fit the positioning boss 122, so that the fixed segment 52 and the base 100 can be positioned more accurately and connected more reliably.

It should be understood that, when the bent segment 51 extends on the side wall of the base 100, a direction in which the light inlet of the accommodating cavity 10 is located also needs to be avoided.

In this embodiment of this application, the bent segment 51 may include three bends. The bent segment 51 extends from an end surface of the main circuit board 21, may, after passing through a bend, be attached to a side wall that is of the base 100 and that is adjacent to the light inlet of the accommodating cavity 10, extends for a specific length on the side wall, may, after passing a second bend, be attached to a side wall that is of the base 100 and that backs onto the light inlet of the accommodating cavity 10, extends for a specific length on the side wall, is attached to the top wall of the base 100 after passing through a third bend, and is connected to the fixed segment 52. The fixed segment 52 may be attached to the top wall of the base 100 by using the reinforcing plate 501. The fixed segment 52 is fastened to the reinforcing plate 501 by using a laser welding process, and the fixed segment 52 is configured to connect a circuit to the outside.

There may be two flexible circuit boards 500. The bent segments 51 of the two flexible circuit boards 500 may be respectively connected to two opposite end surfaces of the main circuit board 21, and the two end surfaces correspond to two side walls that are of the base 100 and that are adjacent to the light inlet of the accommodating cavity 10. The bent segments 51 of the two flexible circuit boards 500 respectively extend to side walls that are of the base 100 and that back onto the light inlet of the accommodating cavity 10. The fixed segments 52 of the two flexible circuit boards 500 may be disposed adjacent to each other, and are attached to the same reinforcing plate 501. In general, the two flexible circuit boards 500 are symmetrically arranged.

The symmetric flexible circuit boards 500 extending from left and right sides of the main circuit board 21 may implement a flexible electrical connection, may also provide rigidity values in X and Y directions for the image stabilization motor, and work with the suspension lines 32. This can ensure that a difference value of the entire image stabilization motor in different postures is small, and ensure stability of image stability performance of the image sensor 22 in different postures in a moving process of the image stabilization motor. That is, the suspension lines 32, the damping adhesive disposed in the mounting hole 11 of the base 100, and the flexible circuit boards 500 disposed on the sides of the main circuit board 21 jointly form a damping system of the image stabilization motor.

In an actual use process, when the movable assembly 200 shifts in the X direction, the left and right sides of the symmetrically bent flexible circuit board 500 provide a counter force reverse to a shifting direction due to resistance to deformation. When the movable assembly 200 shifts in the Y direction, the second bend of the flexible circuit board 500 may provide a counter force reverse to the shifting direction due to resistance to deformation in the Y direction.

In this embodiment of this application, the movable assembly 200 needs to shift and/or roll on a plane on which the image sensor 22 is located, and needs to be implemented by disposing a driving assembly. The driving assembly may include a mover and a stator. The mover may be disposed on the main circuit board 21, and the stator may be fastened in the base 100. The mover and the stator may be a coil and a magnet respectively, or the mover and the stator may be a magnet and a coil respectively. After being electrified, the coil can generate a Lorentz force in a magnetic field environment of the magnet to implement driving, so as to form an electromagnetic driving system.

In a possible implementation, the mover may be a coil, the coil may be disposed on the main circuit board 21, the stator may be a magnet, and the magnet may be fastened in the base 100. Neither of a quantity of coils and a quantity of magnets is specifically limited in this embodiment of this application. Three types of image stabilization compensation: X-axis shift, Y-axis shift, and roll on the XY plane may be implemented by using one or more groups of coil magnets.

In a possible implementation, the driving assembly may include three groups of coils and magnets, to separately implement the three types of image stabilization compensation: X-axis shift, Y-axis shift, and roll on the XY plane.

In this case, a first coil 411, a second coil 412, and a third coil 413 may be disposed on the main circuit board 21, and the first coil 411, the second coil 412, and the third coil 413 may be disposed and fastened on the main circuit board 21 through an SMT (Surface Mount Technology, surface mount technology) or a welding process. A first magnet 421, a second magnet 422, and a third magnet 423 may be fixedly mounted in the base 100. The first magnet 421, the second magnet 422, and the third magnet 423 are respectively disposed above the first coil 411, the second coil 412, and the third coil 413.

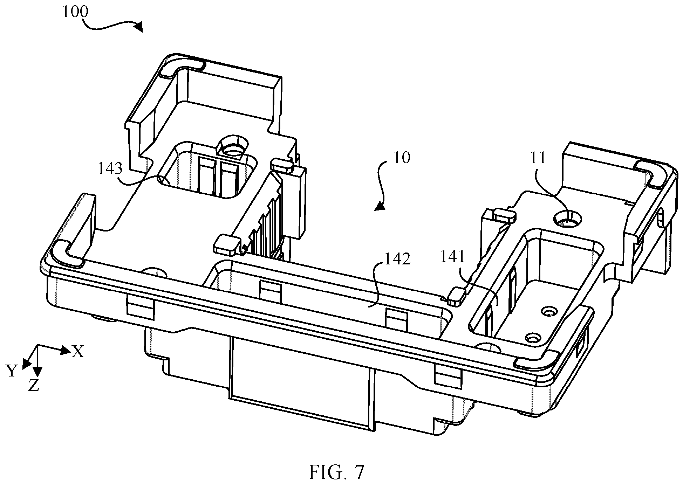

FIG. 7 is a schematic diagram of a structure of a base from another perspective according to an embodiment of this application. Refer to FIG. 7. Mounting cavities 141, 142, and 143 may be disposed in the base 100, and the first magnet 421, the second magnet 422, and the third magnet 423 are respectively fastened in the mounting cavities 141, 142, and 143. The magnet may be a four-pole uniformly magnetized magnet, or two same magnets are connected and fastened together after being magnetized.

A specific position of the coil may not be specifically limited in this embodiment of this application. Because the magnet is located above the coil, a direction of a magnetic induction line generated by the magnet is perpendicular to a plane on which the image sensor 22 is located. According to a left-hand rule, a direction of a Lorentz force generated by the coil in a magnetic field environment is parallel to the plane on which the image sensor 22 is located. It should be understood that a force center line of a Lorentz force generated by the coil in a magnetic field of a corresponding magnet may pass through a center of the image sensor 22, to implement shift driving. Alternatively, a force center line of a Lorentz force generated by the coil in a magnetic field of a corresponding magnet may not pass through a center of the image sensor 22, and a generated torque may implement roll driving. In different situations, the movable assembly 200 can be driven to implement different movements by balancing and controlling driving forces and driving torques of a plurality of groups of coil magnets.

In a feasible implementation, a length direction of the first coil 411 may extend in a first direction (namely, a Y direction), a center line of the second coil 412 may extend in a second direction (namely, an X direction), a perpendicular bisector of the length direction of the first coil 411 may pass through the center of the image sensor 22, and a perpendicular bisector of the length direction of the second coil 412 may pass through the center of the image sensor 22. After being electrified, the first coil 411 generates a Lorentz force in the X-axis direction under an action of a magnetic field of the first magnet 421, and a center line of the force passes through the center of the image sensor 22. The first coil 411 generates no driving torque, and therefore, the movable assembly 200 may be driven to shift on an X-axis. After being electrified, the second coil 412 generates an action force in the Y-axis direction under an action of a magnetic field of the second magnet 422, and a center line of the force passes through the center of the image sensor 22. The second coil 412 generates no driving torque, and therefore, the movable assembly 200 may be driven to shift on a Y-axis.

A length direction of the third coil 413 may extend along the X-axis or the Y-axis. In the figure, extension along the X-axis is used as an example. A perpendicular bisector of the length direction of the third coil 413 may not pass through the center of the image sensor 22. After being electrified, the third coil 413 may generate an action force in the X-axis direction or the Y-axis direction under an action of the third magnet 423, and may generate a torque, to drive the movable assembly 200 to roll on the XY plane.

It should be additionally noted that a shape of the coil may be a rounded rectangle in the figure, and a length direction of the coil is a long side direction of the rounded rectangle. After the coil is electrified, an equivalent current direction is consistent with the length direction. In a same condition, a coil with a greater length is driven by a larger driving force.

In a possible implementation, the first coil 411, the second coil 412, and the third coil 413 may be respectively disposed on three peripheral sides of the light-transmitting hole 211 of the main circuit board 21, and the three sides may be three sides other than the in-light side of the accommodating cavity 10.

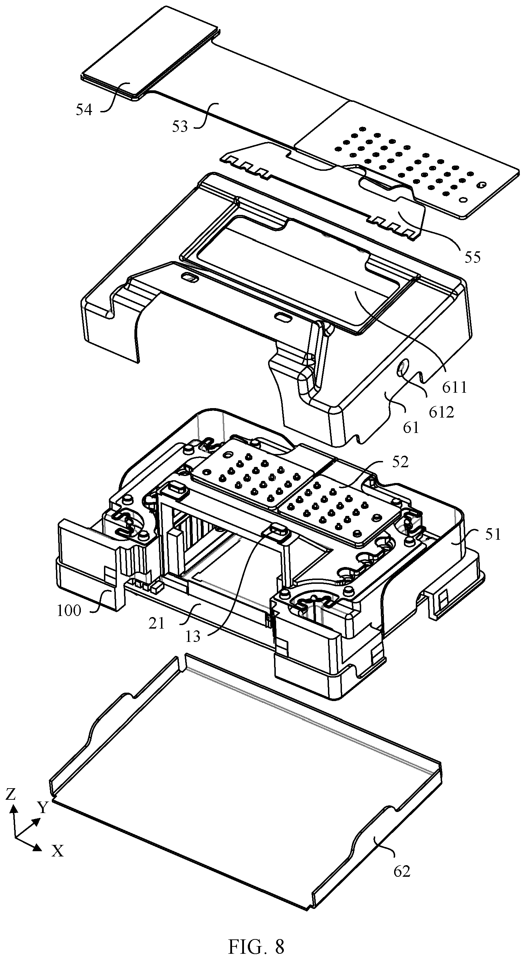

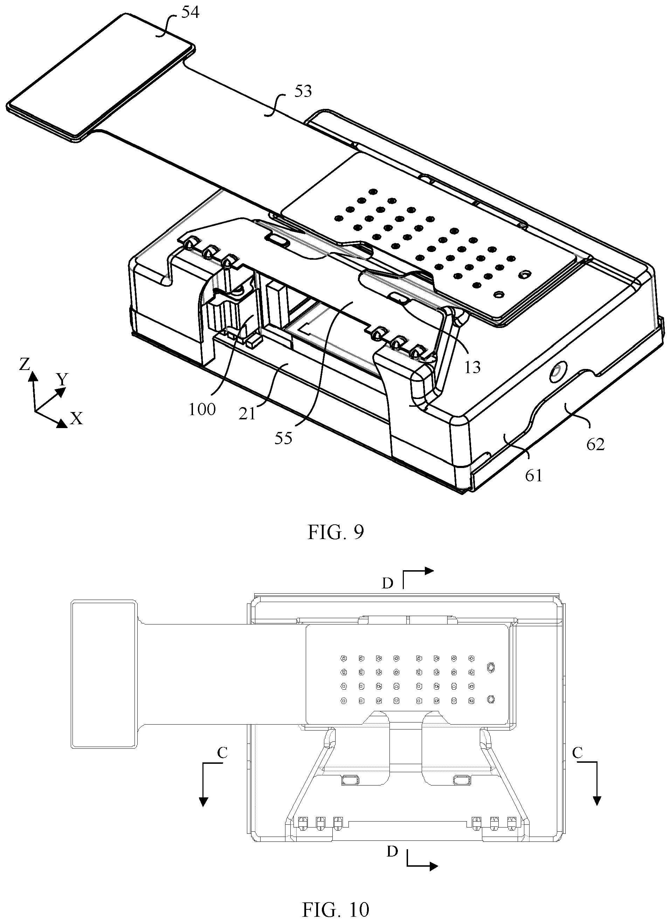

FIG. 8 is a schematic exploded view of a connection structure between a housing of an image stabilization motor and an external circuit according to an embodiment of this application. FIG. 9 is a schematic diagram of a structure of an assembled image stabilization motor according to an embodiment of this application. Refer to FIG. 8 and FIG. 9. The image stabilization motor may further include an upper cover 61 and a lower cover 62, and the upper cover 61 and the lower cover 62 respectively cover the top and the bottom of the base 100, to protect the base 100.

An opening 611 is provided on the upper cover 61. The opening 611 is located above a top wall of the base 100, and is disposed corresponding to the fixed segment 52 of the flexible circuit board 500, so that the fixed segment 52 may be exposed, to implement reliable fastening and an electrical connection with a connection circuit board 53 through laser welding. A connector 54 is disposed at an end part of the connection circuit board 53. The connector 54 may be a board-to-board (Board-to-Board, BTB) connector, and may be fastened to a mainboard in the electronic device, to supply power to the image stabilization motor.

The flexible circuit board 500 may further include a limiting segment 55. The limiting segment 55 is disposed on an upper surface of the upper cover 61, and the limiting segment 55 is connected to the connection circuit board 53. After a power supply signal and a data signal are transmitted from the connector 54 through the connection circuit board 53, a part of the power supply signal and the data signal is transmitted to the main circuit board 21 through the bent segment 51, and the other part of the power supply signal and the data signal is transmitted to the limiting segment 55. Pins may be disposed on a side that is of the limiting segment 55 and that is consistent with the in-light side of the accommodating cavity 10, for example, six pins are disposed in the figure. The limiting segment 55 is configured to connect to another component around the image stabilization motor, for example, a focus module, to implement power transmission and data transmission between the image stabilization motor and the component around. This helps proper arrangement of circuit cabling in the electronic device.

According to another aspect, a limiting boss 13 may be further disposed on the top wall of the base 100. The limiting boss 13 is located above the accommodating cavity 10, and is exposed outside the upper cover 61. There may be two limiting bosses 13. The two limiting bosses 13 are distributed in an X direction from left to right, and the limiting segment 55 may be fastened to the limiting boss 13. In this way, the limiting boss 13 can limit movement of the limiting segment 55 in the X direction and the Y direction, to position the limiting segment 55 and the connection circuit board 53. This can ensure position precision of a welding hole in a laser welding process, and ensure accuracy of the welding process.

It should be noted that, for the image stabilization motor provided in this embodiment of this application, to ensure that there is sufficient space for the accommodating cavity 10 and ensure structural compactness of the image stabilization motor, the top wall of the base 100 may include a main surface and a protruding surface. The protruding surface is higher than the main surface, and the protruding surface is located above the accommodating cavity 10. In this case, the fixed segment 52 is attached to the main surface, the limiting boss 13 is disposed on the protruding surface, and the limiting segment 55 extends to the protruding surface after passing through a bend from the main surface, and is fastened to the limiting boss 13.

In addition, a limiting bump 612 may be further disposed on an inner side wall of the upper cover 61, and the limiting bump 612 protrudes from the inner side wall of the upper cover 61. When the upper cover 61 covers the base 100, the limiting bump 612 may limit movement of the flexible circuit board 500 within a specific range, to form a stable structure of the flexible circuit board.

The limiting bump 612 is used to limit a position of the limiting segment 55 connected to the fixed segment 52, so that the flexible circuit board 500 may be limited to move within a specific range, to form a stable structure of the flexible circuit board 500. This limits a deformation amount of the flexible circuit board 500.

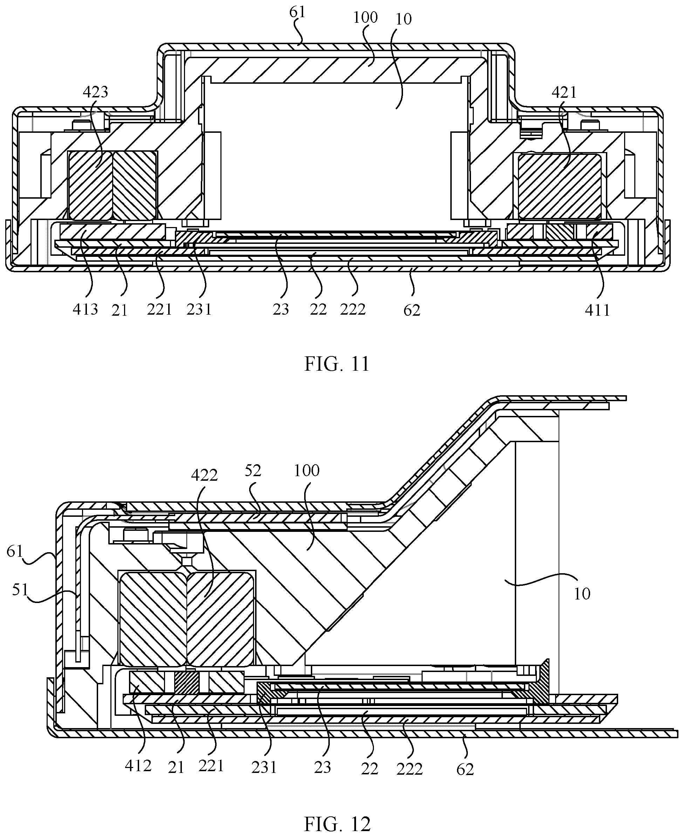

FIG. 10 is a top view of an image stabilization motor according to an embodiment of this application. FIG. 11 is a schematic diagram of a cross section at C-C in FIG. 10. FIG. 12 is a schematic diagram of a cross section at D-D in FIG. 10. Refer to FIG. 10 to FIG. 12. The movable assembly 200 may include a main circuit board 21, an additional circuit board 221, a reinforcing plate 222, an image sensor 22, a bearing table 231, and a light filter 23. The additional circuit board 221 is connected below the main circuit board 21, the reinforcing plate 222 is connected below the additional circuit board 221, the image sensor 22 is connected in the additional circuit board 221, and the bearing table 231 is connected above the additional circuit board 221 and located in the light-transmitting hole 211 of the main circuit board 21. The light filter 23 is connected above the bearing table 231.

The base 100 is located above the movable assembly 200, and the accommodating cavity 10 is located right above the light filter 23 and the image sensor 22. An upper surface of the main circuit board 21 is further connected to the first coil 411, the second coil 412, and the third coil 413. The first magnet 421, the second magnet 422, and the third magnet 423 are fastened in the base 100. The first magnet 421, the second magnet 422, and the third magnet 423 are respectively disposed above the first coil 411, the second coil 412, and the third coil 413.

In an assembling process of the image stabilization motor provided in this embodiment of this application, first, each electronic component may be connected to the main circuit board 21, each magnet is fastened in the base 100, and the spring 31 is fastened to the base 100. Then, the suspension line 32 passes through the base 100, two ends of the suspension line are respectively welded to the spring 31 and the main circuit board 21, and the flexible circuit board 500 is bent and the fixed segment 52 is attached to the top wall of the base 100. Then, the additional circuit board 221 that carries the image sensor 22 and the light filter 23 may be laser-welded to the bottom of the main circuit board 21. Then, the upper cover 61 and the lower cover 62 may be assembled. Finally, the connection circuit board 53 may be laser-welded to the fixed segment 52 of the flexible circuit board 500, and then the connector 54 is fastened to a mainboard in the electronic device.

It should be understood that the base 100, the suspension assembly 300, the driving assembly, the flexible circuit board 500, and the main circuit board 21 may be assembled as an integer. The additional circuit board 221 that carries the image sensor 22 and the light filter 23 is used as an assembling module separately, and then is welded to the main circuit board 21, so that an overall assembling yield rate of the image stabilization motor can be increased.

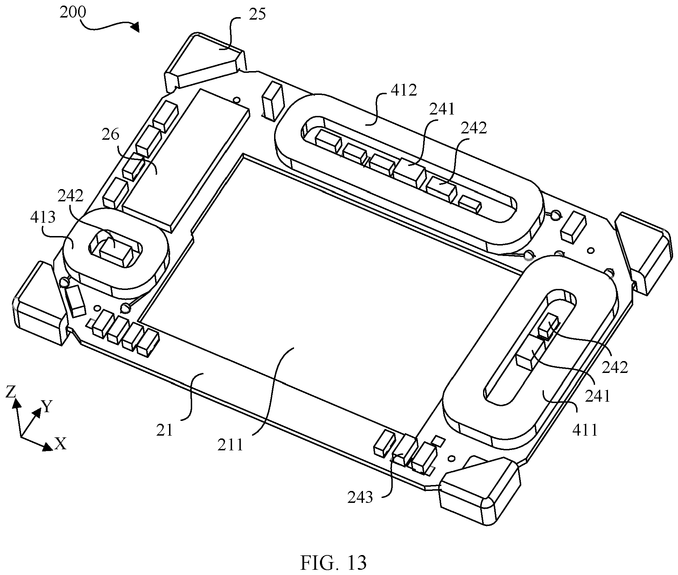

FIG. 13 is a schematic diagram of a structure of a main circuit board according to an embodiment of this application. Refer to FIG. 13. A drive IC (integrated circuit, integrated circuit) 26 may be further disposed on the main circuit board 21. The drive IC 26 may be disposed and fastened on the main circuit board 21 through SMT attachment or a welding process. After receiving jitter data collected by a sensor like a gyroscope in the electronic device, the drive IC may calculate a required displacement compensation amount, and then control a direction and a magnitude of an electrified current of each coil, to control the driving assembly to drive the image sensor 22 to shift or roll.

A magnetic induction device 241 may be further disposed on the main circuit board 21. The magnetic induction device 241 may be disposed and fastened on the main circuit board 21 through SMT attachment or a welding process. The magnetic induction device 241 is configured to sense a magnetic flux. The magnetic induction device 241 may include but is not limited to a Hall effect sensor, a GMR (Giant Magneto Resistance, giant magneto resistance) sensor, or a TMR (Tunnel Magneto Resistance, tunnel magneto resistance) sensor.

There may be three magnetic induction devices 241, which are respectively located at centers of the first coil 411, the second coil 412, and the third coil 413. The three magnetic induction devices 241 are sequentially matched with the first magnet 421, the second magnet 422, and the third magnet 433. By sensing components of a magnetic flux in X/Y/Z directions in different jitter postures, a relative position signal between the image sensor 22 and an optical path center may be monitored, and a position signal of the image sensor 22 is quickly detected again after image stabilization compensation. In this way, position feedback of the image sensor 22 in three directions: X-direction shift, Y-direction shift, and roll on an XY plane is implemented, to determine whether an image stabilization amplitude of the image stabilization motor reaches a preset value.

A temperature sensor 242 may be further disposed on the main circuit board 21, and the temperature sensor 242 may be configured or fastened on the main circuit board 21 through SMT attachment or a welding process. The temperature sensor 242 may be an NTC (Negative temperature coefficient, negative temperature coefficient) temperature sensor, and the temperature sensor 242 may be disposed in a coil and electrically connected to the drive IC 26, to sense temperature information of the main circuit board 21 in an image stabilization process, and perform closed-loop feedback.

In addition, four corners of the main circuit board 21 may be connected to anti-collision parts 25. The anti-collision part 25 may be, for example, an elastic material like a rubber part. The anti-collision parts 25 may be set to be triangular, and are fastened at the four corners of the main circuit board 21, to prevent the movable assembly 200 from colliding with an inner side of the base 100, so as to achieve a buffering and protection function.

In conclusion, according to the image stabilization motor provided in this embodiment of this application, the image sensor shifts on the XY plane, so that the image sensor moves relative to an optical path, to correct a jitter. Synchronously, the image sensor may be driven to roll around a Z-axis on the XY plane by using the driving assembly, to implement jitter correction of a roll angle. The driving assembly includes the coil connected to the movable assembly and the magnet connected to the base. Image stabilization and correction of the image sensor in various shift and roll combination conditions in different directions are implemented by controlling a direction and a magnitude of a current of the coil.

In addition, the image stabilization motor provided in this embodiment of this application integrates the movable assembly, the base, the driving assembly, a flexible circuit board circuit system, the suspension assembly, and the like, and has advantages of high integration and a stable and reliable structure.

With reference to the accompanying drawings and specific embodiments, the following describes in detail an image stabilization principle of the electromagnetic-driven image stabilization motor provided in embodiments of this application.

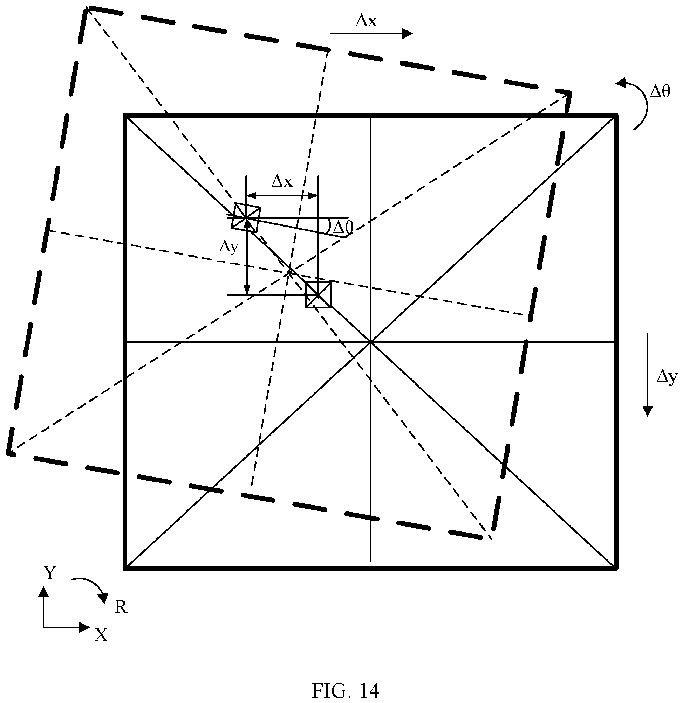

FIG. 14 is a schematic diagram of a principle of an optical image stabilization driving process according to an embodiment of this application. Refer to FIG. 14. A solid box in the figure is an initial position of the image sensor 22, and a dashed box is a position of the image sensor 22 after a jitter occurs. Using a specific point on the image sensor 22 as an example, after the jitter, the point moves leftward by Δx on an X-axis, moves upward by Δy on a Y-axis, and rolls clockwise with an angle roll amount Δθ in an R-axis direction (namely, a rotation axis of an XY plane). The driving assembly should drive the image sensor 22 to move rightward by Δx on the X-axis, move downward by Δy on the Y-axis, and roll anticlockwise by Δθ in the R-axis direction, to eliminate impact of the jitter on imaging.

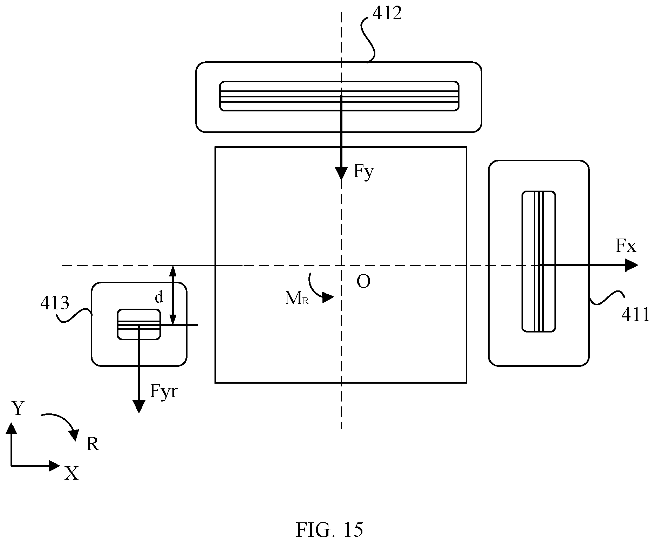

FIG. 15 is a schematic diagram of a driving assembly according to an embodiment of this application. Refer to FIG. 15. In a possible implementation, the driving assembly may include a first coil 411, a second coil 412, and a third coil 413. The first coil 411, the second coil 412, and the third coil 413 are sequentially disposed on three adjacent peripheral sides of an image sensor. A length direction of the first coil 411 may extend in a Y direction, a center line of the second coil 412 may extend in an X direction, and a length direction of the third coil 413 may extend in the X direction. A perpendicular bisector of the length direction of the first coil 411 may pass through a center of the image sensor 22, a perpendicular bisector of the length direction of the second coil 412 may pass through the center of the image sensor 22, and a perpendicular bisector of the length direction of the third coil 413 may not pass through the center of the image sensor 22.

It should be noted that, for the image sensor displacement-type image stabilization motor provided in this embodiment of this application, a mechanical structure design of the movable assembly 200 of the image stabilization motor should ensure that a center of gravity of the movable assembly 200 and a geometric center of the image sensor 22 coincide with force centers of Lorentz forces Fx and Fy in the X-axis and Y-axis directions. In other words, a "three-in-one" mechanical structure is ensured.

According to a Lorentz force and a left-hand rule, it may be determined that after being electrified, the first coil 411 can generate the Lorentz force Fx in the X-axis direction under an action of a magnetic field. After being electrified, the second coil 412 can generate the Lorentz force Fy in the Y-axis direction under an action of a magnetic field. After being electrified, the third coil 413 can generate a Lorentz force Fyr in the X-axis direction under an action of a magnetic field. Because the force centers of Fx and Fy coincide with the center of gravity O of the image sensor 22, Fx and Fy generate no additional torque for O. Therefore, Lorentz forces generated by the first coil 411 and the second coil 412 contribute only to shifting motion of the image sensor in the X direction and the Y direction. However, for Fyr, because a driving force center of Fyr does not coincide with the center O, and a specific force arm d exists, a specific torque MR is generated for O. Under an action of the MR, the image sensor 22 rolls along a roll center, to implement image stabilization suppression of the image sensor 22 in a roll (roll) direction on the XY plane.

In addition, a magnetic induction device may be disposed at each of centers of the first coil 411, the second coil 412, and the third coil 413 respectively, to implement position feedback in three directions: pitch, yaw and roll of the image sensor.

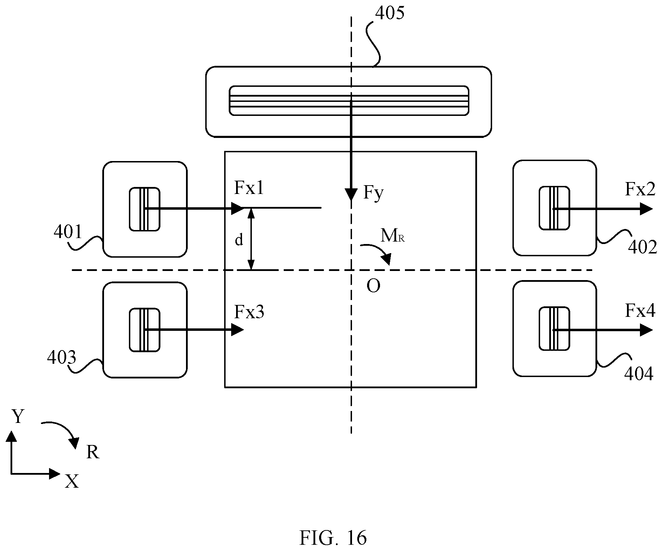

FIG. 16 is a schematic diagram of a driving assembly according to an embodiment of this application. Refer to FIG. 16. In another possible implementation, the driving assembly may include five coils 401 to 405. A periphery of the image sensor may be defined as a first side to a fourth side that are sequentially connected. The coils 401 and 403 may be disposed on the first side, and are separately disposed on two ends of the first side. The coils 402 and 404 may be disposed on the third side and are disposed opposite to the coils 401 and 403. The coil 405 may be disposed on the second side. Length directions of the coils 401 to 404 may all extend in a Y direction, and a perpendicular bisector of the length direction does not pass through a center of the image sensor. A length direction of the coil 405 may extend in an X direction, and a perpendicular bisector of the length direction may pass through the center O of the image sensor.

According to a Lorentz force and a left-hand rule, it may be determined that after the coils 401 to 404 are electrified, Lorentz forces Fx1, Fx2, Fx3, and Fx4 in the X-axis direction and a torque MR may be generated under an action of magnetic fields, so that the image sensor can shift in the X direction and roll in an R-axis direction. After being electrified, the coil 405 can generate a Lorentz force Fy in a Y-axis direction under an action of the magnetic field, so that the image sensor can shift in the Y direction.

The coils 401 to 404 may be four coils of a same size. In case of three-in-one, the coils 401 and 402 may be controlled in series, so that currents of the two coils are the same in size, that is, Fx1=Fx2. The coils 403 and 404 may be controlled in series, so that currents of the two coils are the same in size, that is, Fx3=Fx4. Image stabilization and correction of the image sensor in various shift and roll combination conditions in different directions are implemented by controlling a direction and a magnitude of a current of the coil.

For example, in an X-axis shift mode, Fx1=Fx3/0 and Fy=0 may be controlled. In a Y-axis shift mode, Fy≠0 and Fx1=Fx3=0 may be controlled. In an X+Y dual-axis shift mode, Fx1=Fx3≠0 and Fy≠0 may be controlled. In a roll node on an XY plane, Fx1=-Fx3≠0, and Fy=0 may be controlled. If Fx1 and Fx2 are greater than Fx3 and Fx4, clockwise roll is performed. If Fx1 and Fx2 are less than Fx3 and Fx4, anticlockwise roll is performed.

A size of a roll angle of the image sensor may be controlled by controlling magnitudes of currents in the coils 401 to 404. For an image sensor shift+in-plane roll mode:

In an X-axis direction shift+in-plane roll mode, Fx1≠Fx3≠0, and Fy=0 may be controlled. A value of the torque MR may be represented as: MR = 2d * (Fx 1 - Fx3).

In a Y-axis direction shift+in-plane roll mode, Fy≠0 and Fx1=-Fx3≠0 may be controlled. A direction of the torque MR is controlled by controlling an Fx1 direction, to control a roll direction.

In an X-axis direction shift+Y-axis direction shift+in-plane roll mode, Fx1≠Fx3≠0 and Fy≠0 can be controlled.

Control in the foregoing plurality of scenarios is to control a magnitude of a Lorentz force on the basis of controlling a magnitude of a current of a coil, so as to control displacements compensated in different directions of the image sensor. Directions of currents in coils in different directions are controlled to control directions of Lorenz forces and corresponding torques, so as to control a direction which the image sensor shifts and rolls.

Three magnetic induction devices need to be configured for implementation of the solution, and may be separately disposed at centers of the coils 403, 404, and 405, to implement position feedback in three directions of the image sensor: pitch, yaw, and roll. A single controller element controls output of a single variable, to ensure that a control system outputs a unique solution between movement compensation amounts Δx, Δy, and Δθ and magnetic field intensity in different jitter scenarios. This can reduce errors caused by complex cross coupling.

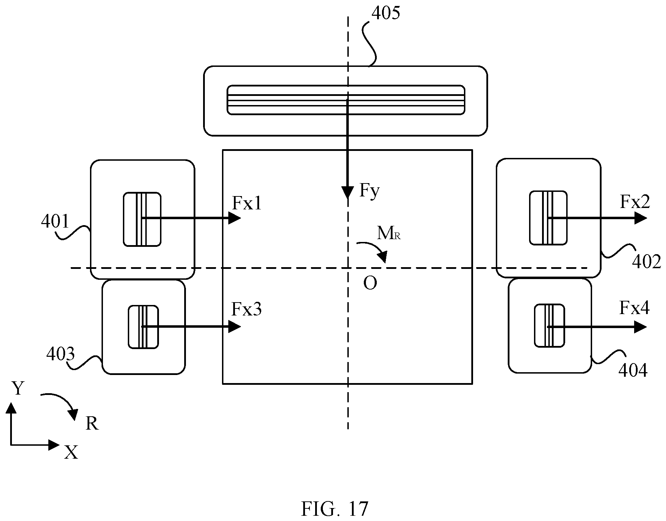

FIG. 17 is a schematic diagram of a driving assembly according to an embodiment of this application. Refer to FIG. 17. A quantity and arrangement of coils in FIG. 17 are the same as those in FIG. 16. Difference lies in that the coils 401 to 404 in FIG. 16 are coils of a same size. In embodiments of this application, the coils 401 to 404 are not limited to ensuring that sizes should be consistent. A size and a relative position of the coil may be correspondingly adjusted based on an electromagnetic thrust and a structure requirement of a mechanical design. For example, to ensure that an optical image stabilization angle in an X-axis direction of the image sensor is large enough in a same size, the sizes of the coils 401 and 402 may be set to be greater than the sizes of the coils 403 and 404.

According to the driving assembly of the image stabilization motor provided in embodiments of this application, an electromagnetic driving solution is a decoupling design, and a high-precision magnetic induction device feedback system is combined, to effectively resolve problems such as unstable optical images, image rotation, crosstalk, and hysteresis that exist in the image stabilization motor in a related technology.

FIG. 3 to FIG. 17 show the structure of the image stabilization motor used in a periscope long-focus camera module. The structure of the image stabilization motor may be further used in a vertical camera module. The following describes in detail a structure of the image stabilization motor provided in this embodiment of this application by using an example in which the image stabilization motor is used in a main camera module or a wide-angle camera module.

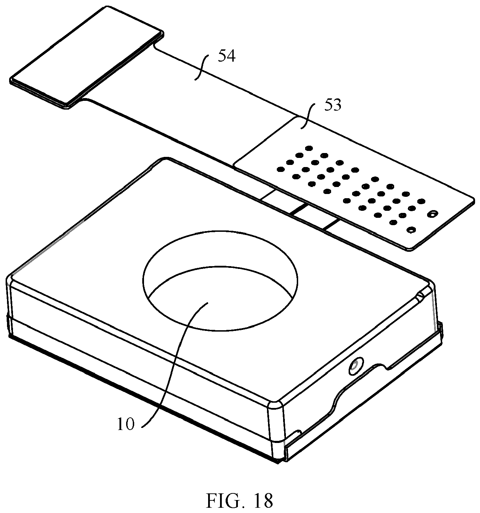

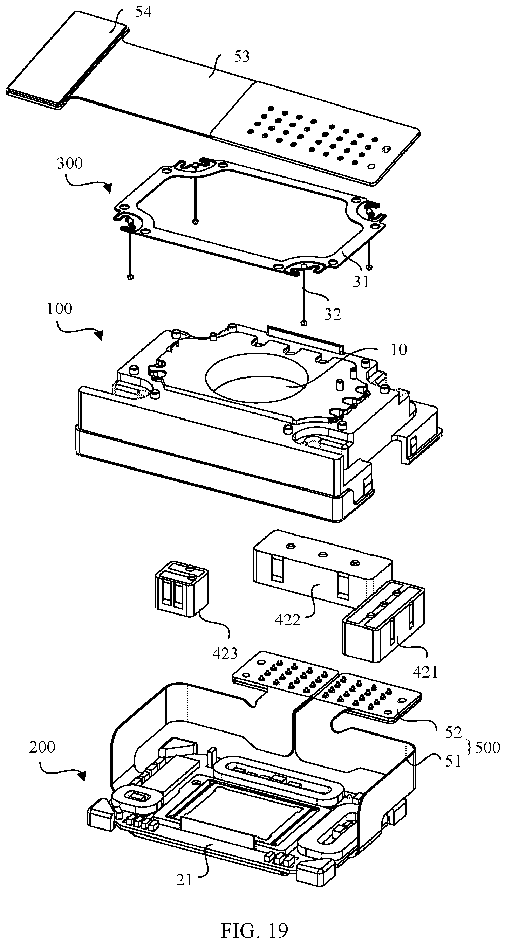

FIG. 18 is another schematic diagram of an image stabilization motor according to an embodiment of this application. FIG. 19 is a schematic exploded view of an image stabilization motor according to an embodiment of this application. Refer to FIG. 18 and FIG. 19. The image stabilization motor provided in embodiments of this application may also include a structure like the base 100, the movable assembly 200, the suspension assembly 300, the driving assembly, and the flexible circuit board 500.

A part that is the same as the structures in FIG. 3 to FIG. 17 is not described herein again. A main difference lies in that, in this embodiment of this application, an optical part accommodated in the base 100 may be a lens, the accommodating cavity 10 may be a cylindrical cavity, the movable assembly 200 is disposed at the bottom of the accommodating cavity 10, and a light inlet of the accommodating cavity 10 is located on a top wall of the base 100.

Correspondingly, it is not difficult to understand that during design of a structure like each structure on the base 100, the movable assembly 200, the suspension assembly 300, the driving assembly, and the flexible circuit board 500, the light inlet of the accommodating cavity 10 only needs to be avoided, to prevent light admission of the lens from being affected.

In this case, the flexible circuit board 500 may also include the bent segment 51 and the fixed segment 52. The fixed segment 52 needs to avoid the light inlet of the accommodating cavity 10, and cannot be attached to the top wall of the base 100. Refer to FIG. 19. The fixed segment 52 may be suspended beside the base 100, and is fastened by using another component around the camera module in the electronic device. Alternatively, the fixed segment 52 may be attached to a side wall of the base 100.

An embodiment of this application further provides a camera module. The camera module may be a periscope long-focus camera module, and includes the image stabilization motor shown in FIG. 3 to FIG. 17. A prism or a periscope reflector is disposed in the image stabilization motor. The image stabilization motor, a lens, and a focus motor may jointly form the camera module.

An embodiment of this application further provides a camera module. The camera module may include the image stabilization motor shown in FIG. 18 and FIG. 19. A lens is disposed in the image stabilization motor. The camera module may be used in a main camera module or a wide-angle camera module.

An embodiment of this application further provides an electronic device, including the camera module provided in the foregoing embodiments of this application. The camera module has a three-axis image stabilization capability, and can implement high-quality image shooting effect, so that competitiveness of the electronic device can be improved.

Finally, it should be noted that the foregoing embodiments are merely intended for describing the technical solutions in embodiments of this application, instead of limiting the technical solutions. Although embodiments of this application are described in detail with reference to the foregoing embodiments, persons of ordinary skill in the art should understand that they may still make modifications to the technical solutions described in the foregoing embodiments or make equivalent replacements to some or all technical features thereof, without departing from the scope of the technical solutions in embodiments of this application.

## Claims

1. An image stabilization motor, comprising a base, a movable assembly, a suspension assembly, a driving assembly, and a flexible circuit board, wherein
the movable assembly is disposed at the bottom of the base, the movable assembly comprises a main circuit board and an image sensor connected to the main circuit board, one end of the flexible circuit board is connected to an end surface of the main circuit board, the other end of the flexible circuit board is connected to a board-to-board connector, and at least a part of the flexible circuit board is attached to a side wall of the base in length; and
the suspension assembly is fixedly connected to the base, the main circuit board is connected to the suspension assembly, the driving assembly comprises a mover and a stator, the mover is fastened to the main circuit board, the stator is mounted in the base and correspondingly disposed above the mover, and the mover is configured to drive, under an action of the stator, the movable assembly to shift and/or roll on a plane on which the image sensor is located.

2. The image stabilization motor according to claim 1, wherein the flexible circuit board comprises a bent segment and a fixed segment, the bent segment is connected between the end surface of the main circuit board and the fixed segment, the bent segment is disposed in a bent manner and is attached to at least two side walls of the base, and the fixed segment is connected to the board-to-board connector by using a connection circuit board.

3. The image stabilization motor according to claim 2, wherein the fixed segment is attached to a top wall of the base, and the fixed segment and the connection circuit board are welded.

4. The image stabilization motor according to claim 2 or 3, wherein there are two flexible circuit boards, and bent segments of the two flexible circuit boards are respectively connected to two opposite end surfaces of the main circuit board.

5. The image stabilization motor according to any one of claims 1 to 4, wherein the flexible circuit board and the main circuit board form a rigid-flexible board.

6. The image stabilization motor according to any one of claims 1 to 5, wherein the suspension assembly comprises a spring and a suspension line, the spring is mounted on the base, one end of the suspension line is fastened to the spring, and the other end of the suspension line is fastened to the main circuit board.

7. The image stabilization motor according to claim 6, wherein a mounting hole is provided on the base, the suspension line passes through the mounting hole, and the mounting hole is filled with a damping adhesive.

8. The image stabilization motor according to claim 6, wherein a positioning boss is disposed on the base, a positioning hole is provided on the spring, and the positioning boss is clamped in the positioning hole.

9. The image stabilization motor according to any one of claims 1 to 8, wherein the mover comprises a first coil and a second coil, the stator comprises a first magnet and a second magnet, a length direction of the first coil extends in a first direction, a length direction of the second coil extends in a second direction, the first direction and the second direction are two directions that are perpendicular to each other on the plane on which the image sensor is located, and both a perpendicular bisector of the length direction of the first coil and a perpendicular bisector of the length direction of the second coil pass through a center of the image sensor; and
the first coil and the first magnet are configured to drive the movable assembly to shift in the second direction, and the second coil and the second magnet are configured to drive the movable assembly to shift in the first direction.

10. The image stabilization motor according to claim 9, wherein the mover further comprises a third coil, the stator further comprises a third magnet, a length direction of the third coil extends in the first direction or the second direction, and a perpendicular bisector of the length direction of the third coil does not pass through the center of the image sensor; and
the third coil and the third magnet are configured to drive the movable assembly to roll on the plane on which the image sensor is located.

11. The image stabilization motor according to any one of claims 1 to 10, wherein the movable assembly further comprises an additional circuit board, the image sensor is fastened to the additional circuit board, and the additional circuit board is welded on a side that is of the main circuit board and that backs onto the base.

12. The image stabilization motor according to claim 11, wherein the movable assembly further comprises a light filter, and the light filter is fastened to the additional circuit board, and is located on a side that is of the image sensor and that faces the base.

13. The image stabilization motor according to any one of claims 1 to 12, wherein a magnetic induction device is further disposed on the main circuit board, and the magnetic induction device is disposed at a center of the mover.

14. The image stabilization motor according to any one of claims 1 to 13, wherein a temperature sensor is further disposed on the main circuit board, and the temperature sensor is disposed in the mover.

15. The image stabilization motor according to any one of claims 1 to 14, wherein the image stabilization motor further comprises a drive IC, and the drive IC is disposed on the main circuit board.

16. The image stabilization motor according to any one of claims 1 to 15, wherein an accommodating cavity is disposed on the base, the accommodating cavity is configured to accommodate an optical part, the image sensor is located on an out-light side of the optical part, an opening is provided on the side wall or the top wall of the base, and the opening is located on an in-light side of the optical part.

17. A camera module, comprising a lens, a prism, and the image stabilization motor according to any one of claims 1 to 16, wherein the prism is mounted in a base, an optical axis direction of the lens is parallel to a plane on which an image sensor is located, and the prism is configured to reflect light from the lens, so that the light is perpendicular to the plane on which the image sensor is located.

18. A camera module, comprising a lens and the image stabilization motor according to any one of claims 1 to 16, wherein the lens is mounted in a base, and an optical axis direction of the lens is perpendicular to a plane on which an image sensor is located.

19. An electronic device, comprising the camera module according to claim 17 or 18.
